# EUROPEAN PATENT APPLICATION

(11) **EP 1 143 378 A1**
(43) Date of publication of application: **10.10.2001**
(21) Application number: 00810291.5
(22) Date of filing: 04.04.2000
(51) Int. Cl.: G06K 19/077

(54) **Method for manufacturing of RFID inlet**

(71) Applicant: Smartag (S) Pte. Ltd., Singapore 569626 (SG)
(72) Inventor: Siong, Lian Tiang, Singapore 464094 (SG); Leong, Tan Geok, Singapore 570263 (SG)
(74) Representative: Patentanwälte Feldmann & Partner AG

(57) **Abstract**

A contact-less inlet and a method for the manufacture of such an inlet in mass volume production is described in this invention. The method involves steps of dispensing adhesive paste on the pads of the antenna **coil**, aligning the bumps on the chip with the corresponding pads, curing of the adhesive and henceforth making the inlet connected electrically. The invention can therefore be applied through large-scale production as the method described has cost and speed advantages.

## Description

### BACKGROUND OF THE INVENTION

### 1. Field of the Invention

This invention relates to a method for the manufacturing of an inlet that carries an integrated circuit (hereinafter "IC") chip. The inlet serves as a radio frequency identification (hereinafter "RFID") device, where it collects the energy to operate from a RF field emitted by a reader device. Therefore the RFID' s are non-contact devices that do not need battery to operate. Such device is designed to perform various applications, ranging from everyday usage to new emerging opportunities. Some of these applications are Access Control, Airline Baggage, Animal & Object Identification, Car Immobilisation, Cash Card, Computer Security, Emergency Response, Home Surveillance, Laundry Tagging, Logistics, Parcel Services, Retailing, Ticketing, Traffic Tolls, Warehousing, Anti-Counterfeiting Measures, Asset Management, Close Circuit Cash-less Systems, Operations Tracking, Outpatient Care Techniques, Personal Autonomy, Personnel Monitoring, Prepayment Programs, Selective Access and Sports Performance Monitoring.

### 2. Description of the Prior Art

Product tagging has long been a Tradition in many trades and industries. The main purpose of tagging includes price listing, product description, country of origin, inventory control, anti-theft and many more other functions. Most of the current tagging methods could only include a few of these functions. However, more and more product information are required to be tagged on as the world progresses. Therefore, the concept of a RFID is conceived and becomes a reality, where most of the product tagging functions is included in one single tag.

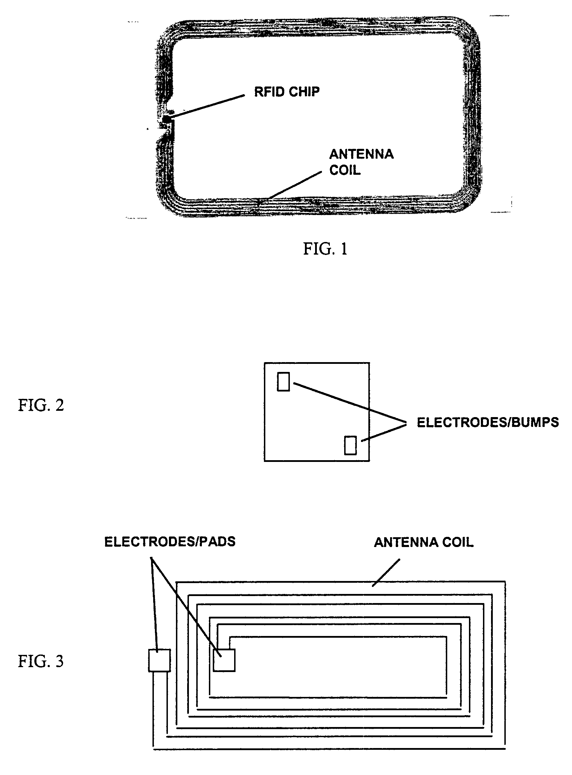

A RFID label is a paper-thin identification label with a programmable IC inside and an antenna connected to it. It communicates through RF signals with a fixed-position or handheld reader/writer over some distances. A RFID label can store user data in the IC's memory, and therefore allows stored data to be modified without the need to replace the label. A RFID label usually consists of 3 layers, two of which is the top and bottom covers with an inlet in between. The covers allow printing while the inlet is the core layer of the RFID label. The inlet is where the circuit and IC are located, as shown in FIG. 1.

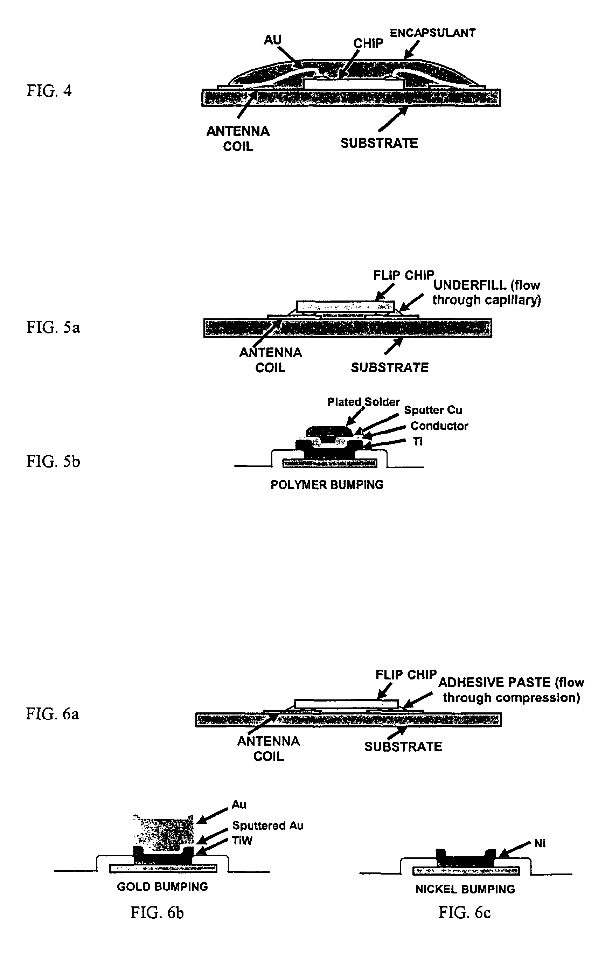

There are known ways of making interconnects between the IC and the circuit. The most popular method being, using a gold wire to bond on both the circuit and the IC. Wire Bonding technique is the oldest technology available in the semiconductor assembly. It is therefore very established and equipment is readily available for mass production. Wire Bonding could also offer low cost solution as its materials such as gold wire and encapsulant are heavily used in the semiconductor assembly. However, one of the major disadvantages of wire bonding technology is the creation of high stand-off. High profile means thicker assembly and larger area. It would be very difficult if not impossible, for inlets with high stand off to be printed. The manufacturing processes of this technology is also more involving, thus more process steps are required, FIG. 4.

Another popular method of interconnection is flip chip, either using polymer flip chip (FIG. 5.) or using anisotropic conductive (U.S. Patent 5,705,852) /non-conductive film (U.S. Patent 5,928,458). The main reason of using flip chip is to achieve a much lower profile than wire bonding. However, the major disadvantage of these flip chip methods is the high cost of manufacturing process of making polymer bumps (as in the latter method) or the complexity of applying a film (as in the latter methods). These henceforth deter the widespread application for the mass production.

### SUMMARY OF THE INVENTION

The present invention is aimed at proposing a method for the manufacturing of the non-contact RFID inlets that overcome the above-mentioned drawbacks, in order to produce in mass quantity. Thus, the current method would make the manufacturing of inlets more efficient and at lower cost.

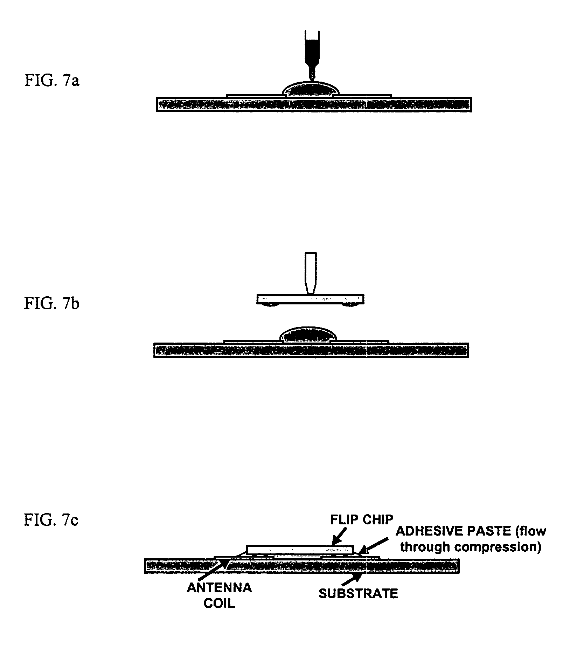

This invention is achieved by, dispensing sufficient amount of adhesive paste onto the antenna coil, FIG. 7a, aligning the electrodes of the IC (or commonly known as bumps) with the electrodes of the antenna coil (or commonly known as pads), FIG. 7b, and curing of the adhesive, FIG. 7c.

The electrodes of the IC (FIG. 2) and antenna coil (FIG. 3) may electrically be connected to each other with pressure through direct attachment. Preferably, this method comprises a step of pressurizing the IC onto the antenna coil and curing of the adhesive paste simultaneously.

The advantages of this invention are utilisation of the most commonly available bumps (i.e. gold or nickel bumps, FIG. 6b & 6c) and the simplicity of dispensing the adhesive paste. This compared favourably with polymer flip chip whereby the bumps (FIG. 5b) are expensive and the paste is applied after the electrodes have connected. Thus the underfill material could only move slowly through capillary action under the polymer flip chip method. This invention is also better than the conductive/non-conductive film method (U.S. Patents 5,705,852 and 5,928,458) as the cost of adhesive paste is much lower than conductive/non-conductive film.

Additional advantage of this invention is that it is suitable to apply onto antenna coils that are stamped, etched, printed or by any other manufacturing methods that attached the antenna coil onto a substrate that acts as a carrier. The substrate material can be paper, PET, PVC, or any other plastic, or any materials that is flexible in bending and in shape. Capitalising on the advantage of a flexible substrate, the completed inlet can then be inserted into a card as a contact-less card, or molded in plastic and silicon as an outdoor tag.

### BRIEF DESCRIPTION OF THE DRAWINGS

FIG. 1 is a view showing the complete inlet in which consists of chip and antenna coil.
FIG. 2 is a typical view of a RFID chip with two 1/0.
FIG. 3 is a view of a typical pattem of an antenna coil.
FIG. 4 is a view of a wire-bonded inlet.
FIG. 5a to 5b are views of polymer flip chip inlet with the details on the bump structure.
FIG. 6a to 6c are views of present invention corresponding to FIG. 1.
FIG. 7a to 7c are views showing mounting steps according to the embodiment of the present invention.

## Claims

1. A method for mounting a RFID chip onto the pads of an antenna coil. The method comprises the following steps in the order mentioned below:
a. dispensing a sufficient amount of adhesive paste on the pads,
b. aligning the bumps on the IC with the corresponding pads of the antenna coil,
c. curing of the adhesive and therefore make the IC and pads connected electrically.

2. A method for mounting a RFID chip according to Claim 1, wherein the bumps are electrically connected to the pads of the antenna coil with pressure and curing of the adhesive paste simultaneously.

3. A method for mounting according to Claim 1, with stracture of Claim 2 whereby antenna coils are stainped, etched, printed or by any other manufacturing methods that attached the antenna coil onto a substrate. The substrate material can be paper, PET, PVC, or any other plastic, or any materials that is flexible.

4. A contact-less card whereby an inlet based on Claim 3 is inserted into plastic card or pouch.

5. An outdoor tag whereby the inlet based on Claim 3 is molded in plastic or silicon.
